# FASCICULE DE BREVET EUROPEEN

(11) **EP 0 388 329 B1**
(45) Date de publication et mention de la délivrance du brevet: **05.06.1996**
(21) Numéro de dépôt: 90420132.4
(22) Date de dépôt: 12.03.1990
(51) Int. Cl.: H03K 17/04, H03K 17/06

(54) **Circuit de commande de transistor MOS de puissance sur charge inductive**
Steuerschaltung für einen MOS-Leistungstransistor mit induktiver Last
Driver circuit of a power MOS transistor with inductive load

(30) Priorité: 15.03.1989 FR 8903636
(43) Date de publication de la demande: 19.09.1990
(73) Titulaire: SGS-THOMSON MICROELECTRONICS S.A., F-94250 Gentilly (FR)
(72) Inventeur: Le Roux, Gérard, F-38700 La Tronche (FR)
(74) Mandataire: de Beaumont, Michel

(56) Documents cités:
- EP-A- 0 132 861
- EP-A- 0 179 693
- EP-A- 0 239 861
- EP-A- 0 337 857

## Description

La présente invention concerne le domaine des transistors MOS de puissance, et plus particulièrement les transistors MOS de puissance réalisés selon la technologie dite DMOS (MOS diffusé) à canal N qui nécessitent, quand leur drain est relié à une source d'alimentation et leur source à une charge, une tension de grille supérieure à la tension d'alimentation. Le cas des transistors MOS de puissance reliés à une charge du type charge inductive est plus précisément concerné.

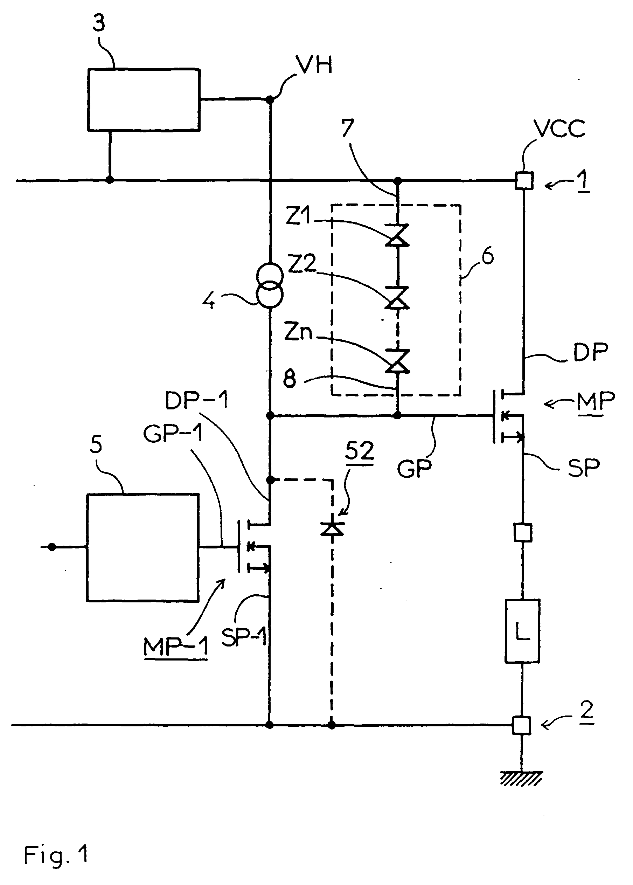

La figure 1 représente une première manière de réaliser un circuit dans lequel une charge inductive L est reliée à la source SP d'un transistor MOS de puissance MP dont le drain DP est connecté à la première borne 1 de la source d'alimentation, la borne libre de la charge étant connectée à la deuxième borne 2 de cette source d'alimentation. La borne 1 de la source d'alimentation délivre une tension VCC positive et la borne 2 est connectée à la masse.

Un circuit élevateur de tension 3, qui est interne au circuit et qui fournit une tension VH supérieure à la tension d'alimentation VCC, est relié à la grille GP du transistor MOS MP par l'intermédiaire d'une source de courant 4. La grille GP est en outre reliée au drain DP-1 d'un transistor MOS de type diffusé DMOS MP-1 dont la source SP-1 est connectée à la borne 2 de la source d'alimentation et dont la grille GP-1 est reliée à un circuit de commande 5.

Schématiquement, le circuit de commande 5 fournit sur la grille GP-1 des signaux de tension d'un niveau bas et des signaux de tension d'un niveau haut pour commander le transistor MP-1. Dans le cas de signaux de niveau bas, le transistor MOS MP-1 est bloqué et le transistor MOS MP est passant.

Lorsque les signaux appliqués sur la grille GP-1 passent du niveau bas au niveau haut, le transistor MP-1 devient passant. Ce transistor absorbe le courant provenant de la source de courant 4, ce qui entraîne le blocage du transistor MOS MP.

Or, lorsque l'on interrompt l'alimentation d'une charge inductive, il se produit à ses bornes une surtension donnée par la relation V = -Ldi/dt. La tension sur la source SP du transistor MP tend à chuter sous la masse.

Lorsque l'on ouvre le transistor MP, il est souhaitable que la charge inductive se décharge au plus vite, c'est-à-dire que la quantité di/dt soit la plus grande possible. On souhaite donc que la tension sur la source de ce transistor puisse chuter de manière importante. Par ailleurs, si la tension de source chute, la tension de grille chute également à la tension de seuil VTP du transistor MP près. Or une tension de grille trop basse entraînerait notamment le claquage du transistor. Il est ainsi prévu un dispositif de verrouillage 6 constitué par un ensemble de n diodes Zener Z1, Z2, ..., Zn en série dans lequel la diode Z1 a sa cathode 7 connectée à la borne 1 de la source d'alimentation et dans lequel la diode Zn a son anode 8 reliée à la grille du transistor MP. La chute de tension sur la source du transistor MP est limitée à une tension de verrouillage donnée par la quantité VCC-(nVZ+VTP), où VZ est la tension Zener de chacune des diodes Zener Z1, Z2, ..., Zn. La tension d'alimentation VCC est par exemple de 35 V. La chute de tension totale correspondant à la somme des n tensions Zener des diodes Z1, Z2, ..., Zn est par exemple 50 V. La tension de seuil VTP entre la grille et la source du transistor MOS MP est de l'ordre de 3 V. Ainsi la tension de source du transistor MP peut descendre a priori jusqu'à une tension de verrouillage de l'ordre de -20 V.

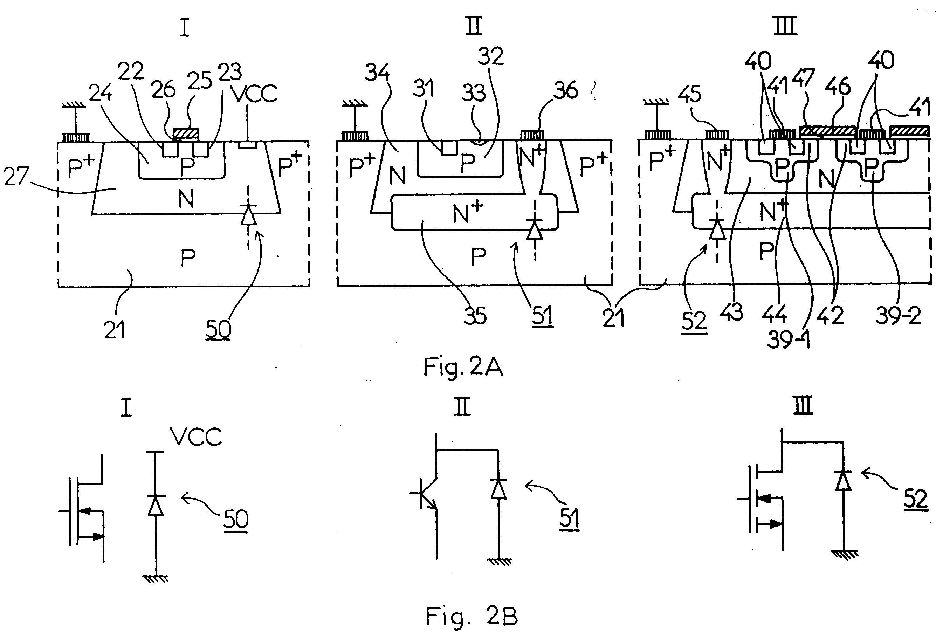

Le circuit de la figure 1 est couramment réalisable sans difficultés. Un circuit de ce type, réalisé sous forme d'éléments discrets, est par exemple décrit dans EP-A-0 239 861. Cependant, il s'avère que pour le type de technologie utilisé qui est présenté aux figures 2A et 2B, le transistor MOS de type diffusé MP-1 empêche la chute de tension jusqu'à la tension de verrouillage.

La figure 2A représente en coupe un transistor MOS logique (partie I), un transistor bipolaire NPN (partie II) et une partie d'un transistor MOS de puissance (partie III) avec une technologie susceptible de les incorporer dans une même puce de circuits intégrés. Les dispositifs sont réalisés sur un substrat 21 de type P.

Dans le transistor logique I, deux diffusions de type N 22, 23 sont réalisées dans un caisson 24 de type P pour constituer les drain et source, respectivement. La grille 25 du transistor prend place au-dessus d'une couche d'oxyde de grille 26. Le caisson de type P 24 est lui-même situé dans un autre caisson 27 de type N qui est relié à la borne de la source d'alimentation qui délivre la tension positive VCC. Le substrat est relié à la masse.

Le transistor bipolaire NPN II comprend un émetteur 31 constitué par une diffusion de type N dans un caisson de type P 32 qui forme lui-même la base du transistor. Le contact de base est pris sur une région surdopée P⁺ 33. Le caisson de type P 32 est situé dans un caisson de type N 34 qui constitue le collecteur. Le caisson 34 est en contact avec une couche enterrée 35 de type N+ reliée à un contact de collecteur 36.

Un transistor MOS de puissance de type diffusé (DMOS) comprend un ensemble de cellules dont l'une est représentée dans la partie III de la figure 2A. Une cellule comprend deux régions 39-1, 39-2 constituées par des diffusions de type P. Dans chaque région 39-1, 39-2 sont réalisées deux diffusions 40 de type N qui constituent la source du transistor de puissance. Les deux diffusions 40 sont connectées entre elles par une couche conductrice 41. Les bords latéraux des régions 39-1, 39-2 constituent les régions de canal 42. Les régions 39-1, 39-2 sont situées dans un caisson 43 de type N formant le drain du transistor. Ce caisson 43 est en contact avec une couche enterrée de type N+ 44 reliée à un contact de drain 45. Chaque cellule comprend une grille 46 située au-dessus d'une couche d'oxyde de grille 47.

La figure 28 représente dans les parties I, II et III les symboles des transistors présentés dans les parties I, II et III de la figure 2A, respectivement. A côté de chaque symbole de transistor est représentée une diode présente dans la structure. Les symboles de ces diodes sont représentés dans les structures de la figure 2A. Dans la partie I, une diode 50 est formée entre le substrat 21 et le caisson de type N 27. Son anode est connectée à la masse et sa cathode à la borne de la source d'alimentation qui délivre la tension VCC. La structure de la partie II présente une diode 51 entre le substrat 21 et la couche enterrée de type N+ 35. Son anode est connectée à la masse et sa cathode au collecteur du transistor bipolaire. Dans la partie III, une diode 52 est située entre le substrat 21 et la couche enterrée de type N+ 44. Son anode est connectée à la masse et sa cathode au drain du transistor de puissance.

Sur la figure 1, la diode 52 dans le transistor MOS de type diffusé MP-1 est représentée en pointillés. Cette diode 52 présente à ses bornes une chute de tension VD lorsqu'elle est polarisée en direct. Ainsi, à l'ouverture du transistor MOS MP, la tension sur la source SP de ce transistor MP ne peut pas descendre en dessous de la valeur -(VD+TP), c'est-à-dire -3,7 V. La tension de verrouillage susmentionnée, de l'ordre de -20 V, n'est pas atteinte.

Si l'on remplace le transistor MOS de type diffusé MP-1 par un transistor bipolaire, on se trouve confronté au même problème à cause de la présence de la diode 51.

Le seul type de transistor pouvant remplacer le transistor MOS de type diffusé MP-1 est le transistor MOS logique. La diode 50 dans ce transistor ne pertube pas le fonctionnement du circuit.

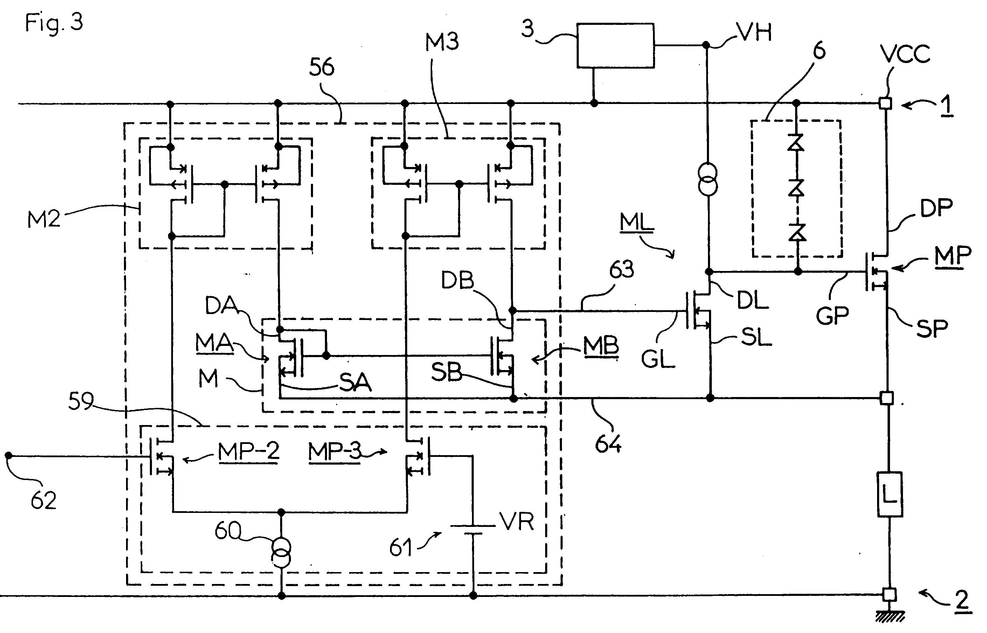

Une deuxième manière de réaliser un circuit dans lequel une charge inductive L est alimentée par l'intermédiaire d'un transistor MOS de puissance MP est représentée sur la figure 3. Dans ce circuit, le transistor MP a sa grille GP reliée au drain DL d'un transistor MOS logique ML. Un dispositif élévateur de tension 3 et un dispositif de verrouillage 6 sont disposés tels qu'ils le sont sur la figure 1.

Un circuit de commande classique 56 est représenté en détail. Il est alimenté par la source d'alimentation du circuit. Cela permet au dispositif élévateur de tension 3 d'alimenter uniquement la grille du transistor MP. Le circuit de commande comprend un étage différentiel 59 formé d'une source de courant 60, d'une source de tension de référence 61 délivrant une tension de référence VR et deux transistors MOS MP-2 et MP-3 de type diffusé DMOS à une cellule. La grille du transistor MP-2 constitue l'entrée 62 du circuit de commande. Les transistors MP-2 et MP-3 sont reliés à des miroirs de courant M2, M3, respectivement, qui sont eux-mêmes composés chacun d'une paire de transistors MOS à canal P agencés de la façon représentée. Le miroir de courant M2 est relié au drain DA d'un transistor MOS logique MA et le miroir de courant M3 est relié au drain DB d'un transistor MOS logique MB, les transistors MA et MB étant également agencés en un miroir de courant M de la façon représentée. Le drain DE du transistor MB constitue la sortie 63 du circuit de commande 56, cette sortie étant connectée à la grille GL du transistor MOS logique ML. Les sources SA et SB des transistors MA et MB, respectivement, sont connectées entre elles et à la source SL du transistor ML par l'intermédiaire d'une connexion auxiliaire 64. La source du transistor ML est elle-même connectée à la source SP du transistor MP.

Un circuit de commande tel que le circuit 56, avec une alimentation appropriée, fonctionne de la manière suivante. Lorsque la tension sur l'entrée 62 du circuit de commande est supérieure à la tension de référence VR, le transistor MP-2 de l'étage différentiel est passant et le transistor MP-3 est bloqué. Puisque le transistor MP-2 est passant, les transistors du miroir de courant M2, et ainsi les transistors du miroir de courant M, sont passants. Inversement, puisque le transistor MP-3 est bloqué, les transistors du miroir de courant M3 sont bloqués. La tension sur la sortie 63 du circuit de commande est mise à un niveau bas pour rendre le transistor ML bloqué et le transistor MOS de puissance MP passant.

Lorsque la tension sur l'entrée 62 du circuit de commande est inférieure à la tension de référence VR, le transistor MP-2 et les transistors des miroirs de courant M2 et M sont bloqués. Le transistor MP-3 et les transistors du miroir de courant M3 sont passants. La tension sur la sortie 63 du circuit de commande est mise à un niveau haut pour rendre le transistor ML passant et le transistor MP bloqué.

Dans le type de technologie utilisé, les transistors MA et MB sont nécessairement des transistors MOS logiques. En effet, si l'on utilisait des transistors MOS de type diffusé DMOS ou des transistors bipolaires, on se trouverait en présence de diodes 52 ou de diodes 51, respectivement (figures 2A et 2B). Si le substrat venait à être coupé de la masse, des signaux pertubateurs pourraient être transmis sur les drains ou collecteurs de ces transistors par l'intermédiaire des diodes. Cela affecterait notamment la tension de grille du transistor MOS logique ML.

Les transistors MOS logiques MA et MB, ainsi que le transistor MOS logique ML, présentent la caractéristique d'être placés dans un caisson de type N (caisson 27 sur la figure 2A) qui est lui-même relié à la source d'alimentation. Les tensions sur leurs sources, grilles et drains peuvent ainsi largement descendre sous la tension du substrat qui est relié à la masse. Ainsi, la tension sur la source SP du transistor MP peut descendre jusqu'à la tension de verrouillage.

Il se pose cependant un problème dans la phase où l'entrée 62 du circuit de commande est à l'état haut pour rendre le transistor MOS de puissance MP passant. En effet, dans le cas où un tel transistor MOS de puissance est passant, la chute de tension entre le drain et la source est faible ; elle est par exemple de l'ordre de 0,3 V. La tension sur les sources SA et SB des transistors MA et MB, respectivement, serait alors égale à la tension d'alimentation VCC moins 0,3 V. Par ailleurs, on a vu que les transistors MOS logiques MA et MB étaient mis à l'état passant pour que le transistor MP soit lui-même passant. Or pour qu'un transistor MOS logique soit passant, sa tension de drain doit être supérieure à sa tension de source d'au moins une tension seuil V_{L} qui vaut environ 1,5 V. La tension sur les drains des transistors MOS logiques MA et MB devrait donc être nettement supérieure à la tension d'alimentation VCC. Ainsi, en raison de la nécessité de prendre pour les transistors MA et MB des transistors MOS logiques dans la technologie utilisée et présentée aux figures 2A et 2B, on arrive à une incompatibilité avec le fait que le circuit de commande soit alimenté par la source d'alimentation. On se trouve donc confronté au problème de l'impossibilité de commander le transistor ML avec un circuit de commande relié à la source d'alimentation quand l'entrée 62 est à l'état haut pour rendre le transistor MP passant.

La solution qui consisterait à alimenter le circuit de commande avec le circuit élévateur de tension n'est pas envisageable, ce circuit élévateur alimentant déjà la grille du transistor MOS de puissance MP et ne pouvant supporter en plus la charge du circuit de commande.

La présente invention propose un circuit à transistor MOS de puissance MP dans lequel la source du transistor MP peut descendre jusqu'à la tension de verrouillage et dans lequel le circuit de commande, tout en étant alimenté par la source d'alimentation, permet de commander le transistor MOS logique ML quand l'entrée du circuit de commande est à l'état haut.

Plus précisément, la présente invention prévoit un circuit comprenant un transistor MOS de puissance connecté par son drain à une première borne de la source d'alimentation et par sa source à une charge inductive dont la borne libre est connectée à la deuxième borne de la source d'alimentation. Ce circuit est réalisé dans une technologie pouvant incorporer dans une même puce de circuits intégrés des transistors MOS de puissance, des transistors MOS logiques et des transistors bipolaires, le substrat relié à la masse constituant d'une part dans les transistors MOS de puissance l'anode d'une diode dont la cathode est formée par le drain et d'autre part dans les transistors bipolaires l'anode d'une diode dont la cathode est formée par le collecteur. La grille du transistor MOS de puissance est reliée d'une part à un circuit élévateur de tension et d'autre part au drain d'un transistor MOS logique. Un circuit de commande alimenté par la source d'alimentation a une sortie connectée à la grille du transistor MOS logique et est connecté par une connexion auxiliaire à la source du transistor MOS logique, la connexion auxiliaire pouvant supporter une chute de tension importante. Des moyens pour limiter la tension de source du transistor MOS logique à une tension inférieure à la tension d'alimentation moins une tension seuil déterminée lorsque le transistor MOS de puissance est passant sont prévus, d'où il résulte que le circuit de commande peut commander la commutation du transistor MOS logique avec la tension d'alimentation disponible à partir de la source d'alimentation.

Ces objets, caractéristiques et avantages ainsi que d'autres de la présente invention seront exposés plus en détail dans la description suivante d'un mode de réalisation particulier faite en relation avec les figures jointes parmi lesquelles :
la figure 1, déjà décrite, représente une première manière classique de réaliser un circuit pour alimenter une charge inductive par l'intermédiaire d'un transistor MOS de puissance,
les figures 2A et 2B représentent d'une part les structures en coupe d'un transistor MOS logique, d'un transistor bipolaire NPN et d'une partie de transistor MOS de puissance (figure 2A) et d'autre part les symboles associés à ces dfférents types de transistors (figure 2B),
la figure 3 représente une deuxième manière de réaliser un circuit pour alimenter une charge inductive par l'intermédiaire d'un transistor MOS de puissance ; et
la figure 4 représente un circuit pour alimenter une charge inductive par l'intermédiaire d'un transistor MOS de puissance selon l'invention.

De façon générale, comme cela est classique dans la représentation des circuits intégrés, on notera que les diverses figures ne sont pas représentées à l'échelle ni d'une figure à l'autre, ni à l'intérieur d'une même figure, et notamment que les épaisseurs des couches sont dessinées arbitrairement dans le but de faciliter la lecture des figures.

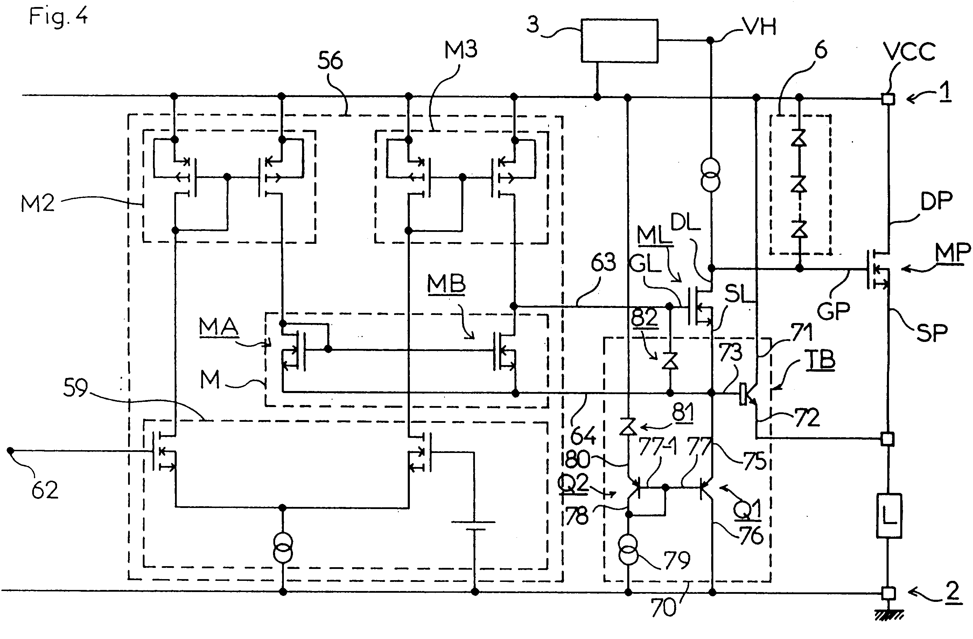

La figure 4 représente un circuit comprenant comme dans la figure 3 un transistor MOS de puissance MP, une charge inductive L, un circuit élévateur de tension 3 et un dispositif de verrouillage 6. Un circuit de commande 56, alimenté par la source d'alimentation du circuit, a une entrée 62 et une sortie 63 qui est connectée à la grille GL d'un transistor MOS logique ML dont le drain DL est relié à la grille GP du transistor MP. Le circuit de commande est relié à la source SL du transistor ML par une connexion auxiliaire 64.

Par rapport à la figure 3, un circuit limiteur de tension 70 a été rajouté. Il comprend un transistor bipolaire NPN TB dont le collecteur 71 est connecté à la borne 1 de la source d'alimentation et dont l'émetteur 72 est connecté à la source SP du transistor MOS de puissance MP. La base 73 du transistor bipolaire TB est d'une part connectée à la source SL du transistor MOS logique ML et est d'autre part connectée à l'émetteur 75 d'un transistor bipolaire PNP Q1 dont le collecteur 76 est relié à la masse et dont la base 77 est connectée à la base 77-1 d'un deuxième transistor PNP Q2 et est connectée au collecteur 78 de ce transistor Q2. Le collecteur 78 de ce transistor Q2 est connecté à la masse par l'intermédiaire d'une source de courant 79. L'émetteur 80 du transistor Q2 est relié à l'anode d'une diode Zener 81 dont la cathode est reliée à la borne 1 de la source d'alimentation. Une autre diode Zener 82 est connectée par son anode à la base 73 du transistor bipolaire TB et par sa cathode à la grille GL du transistor MOS logique ML.

Dans la phase où l'entrée 62 du circuit de commande est à l'état haut pour rendre le transistor MP passant, le transistor MOS logique ML étant bloqué, la tension VSL sur la source SL de ce transistor ML est donnée par : VSL = VCC-VZ-VBE2+VBE1, où la tension VZ est la tension Zener de la diode Zener 81 et où les tensions VBE1 et VBE2 sont les tensions entre bases et émetteurs des transistors Q1 et Q2, respectivement. Avec des transistors Q1 et Q2 similaires, les tensions VBE1 et VBE2 se compensent dans le calcul. La tension sur la source du transistor ML, et également sur les sources des transistors MOS logiques MA et MB, est alors égale à la tension d'alimentation VCC moins la tension Zener VZ de la diode Zener 81. Si cette tension Zener est supérieure à la tension seuil VL d'un transistor MOS logique qui vaut environ 1,5 V, les transistors MA et MB peuvent être mis à l'état passant alors que le circuit de commande est alimenté par la source d'alimentation. On pourra choisir une diode Zener 81 ayant une tension Zener égale par exemple à 5 V.

A l'ouverture du transistor MP, la tension sur sa source SP tend à chuter. En raison de la présence de la diode base-émetteur du transistor bipolaire TB, la tension sur la source SL du transistor ML est amenée à suivre cette chute à un seuil de diode près. Le transistor Q1 se bloque à cause de la mise en inverse de la jonction émetteur-base. Comme on l'a vu précédemment, les transistors MOS logiques MA, MB et ML peuvent descendre sous la tension du substrat. La tension sur la source SP du transistor MP peut donc chuter jusqu'à la tension de verrouillage.

Le transistor TB est utilisé en diode. C'est toutefois un aspect de l'invention que d'utiliser un transistor et non pas une diode. En effet, dans la technologie utilisée, une diode PN a son anode de type P située dans un caisson de type N formant sa cathode. Le caisson de type N est lui-même en contact avec le substrat de type P. Il existerait donc une diode parasite entre le substrat relié à la masse et la cathode de la diode PN.

Dans le circuit de la figure 4, le transistor bipolaire TB a son collecteur relié à la borne 1 de la source d'alimentation. Ainsi, la diode parasite entre le substrat et le collecteur ne risque pas de perturber le circuit.

La diode Zener 82 permet de limiter la tension sur la grille du transistor MOS logique ML. En effet, dans la phase où l'entrée 62 du circuit de commande est à l'état bas, la tension de grille du transistor ML serait proche de la tension VCC sans cette diode Zener 82. La tension d'alimentation VCC est par exemple de 35 V. Le fait d'appliquer une tension aussi élevée sur la grille d'un transistor MOS logique est néfaste. La valeur de la tension Zener de la diode Zener 82 est par exemple 5 V.

Le courant arrivant sur la base du transistor bipolaire TB, quand l'entrée 62 du circuit de commande est à l'état bas, est la somme d'un courant provenant du circuit élévateur de tension 3 et d'un courant provenant du miroir de courant M3 par l'intermédiaire de la diode Zener 82. Le courant en provenance du circuit élévateur de tension vaut par exemple 100 mA. Le courant traversant la diode Zener 82 est de l'ordre de 10 mA. En négligeant en première approximation le courant dans la diode Zener, et si l'on considère un transistor bipolaire TB ayant un gain de 100, il passe dans le collecteur de ce transistor un courant de 10 mA. Par ailleurs, la tension entre le collecteur et l'émetteur du transistor TB peut atteindre une cinquantaine de volts si l'on additionne la tension d'alimentation et la tension de verrouillage. La puissance que doit supporter le transistor est alors de 500 mW. Le transistor doit avoir des dimensions importantes. Cependant, il est possible de limiter le gain en surdopant la région formant la base de ce transistor (caisson 32 dans la figure 2A). On peut atteindre un gain inférieur à 10. La puissance que le transistor doit supporter n'est plus alors que de l'ordre de 50 mW. Ainsi, selon une variante de l'invention, on prévoit un transistor bipolaire TB à faible gain, ce qui permet de réduire de façon notable ses dimensions.

Dans le mode de réalisation présenté, on utilise un circuit élévateur de tension pour alimenter uniquement la grille du transistor MOS de puissance MP et on utilise un circuit de commande du type logique (les transistors de l'ensemble du circuit peuvent occuper deux états : soit l'état passant, soit l'état bloqué), ce circuit de commande fonctionnant entre le niveau de la tension d'alimentation VCC et un niveau de tension inférieur à la masse. Il est clair que l'on peut remplacer le circuit de commande logique par un circuit de commande analogique fonctionnant également entre la tension VCC et le niveau de tension inférieur à la masse, pour réaliser par exemple une régulation de la tension de source du transistor MOS de puissance.

## Revendications

1. Circuit integré comprenant :
un transistor MOS de puissance (MP) connecté par son drain (DP) à une première borne (1) de la source d'alimentation et par sa source (SP) à une charge inductive (L) dont la borne libre est connectée à la deuxième borne (2) de la source d'alimentation, ce circuit étant réalisé dans une technologie pouvant incorporer dans une même puce de circuits intégrés des transistors MOS de puissance, des transistors MOS logiques et des transistors bipolaires, le substrat relié à la masse constituant d'une part dans les transistors MOS de puissance l'anode d'une diode dont la cathode est formée par le drain et d'autre part dans les transistors bipolaires l'anode d'une diode dont la cathode est formée par le collecteur, la grille (GP) du transistor MOS de puissance étant reliée d'une part à un circuit élévateur de tension (3) et d'autre part au drain (DL) d'un transistor MOS logique (ML), et
un circuit de commande (56) alimenté par la source d'alimentation ayant une sortie (63) connectée à la grille (GL) du transistor MOS logique et étant connecté par une connexion auxiliaire (64) à la source (SL) du transistor MOS logique, la connexion auxiliaire pouvant supporter une chute de tension importante,
caractérisé en ce qu'il comprend en outre des moyens pour limiter la chute de tension drain/source de transistor MOS logique (ML) à une tension de l'ordre de sa tension seuil grille/source lorsque le transistor MOS de puissance (MP) est passant, d'où il résulte que le circuit de commande peut commander la commutation du transistor MOS logique avec la tension d'alimentation disponible à partir de la source d'alimentation.

2. Circuit selon la revendication 1, caractérisé en ce que les moyens pour limiter la tension de source du transistor MOS logique consistent en un circuit limiteur de tension (70) comprenant
- un transistor bipolaire NPN (TB) dont le collecteur (71) est connecté à la première borne (1) de la source d'alimentation, dont l'émetteur (72) est connecté à la source (SP) du transistor MOS de puissance (MP) et dont la base (73) est connectée à la source (SL) du transistor MOS logique (ML),
- un premier transistor bipolaire PNP (Q1) dont l'émetteur (75) est connecté à la source du transistor MOS logique et dont le collecteur (76) est relié à la deuxième borne (2) de la source d'alimentation,
- un deuxième transistor bipolaire PNP (Q2) dont la base (77-1) est reliée à la base (77) du premier transistor bipolaire PNP, dont le collecteur (78) est d'une part connecté directement à la base du premier transistor bipolaire PNP et est d'autre part relié à la deuxième borne de la source d'alimentation par l'intermédiaire d'une source de courant (79), l'émetteur (80) du deuxième transistor bipolaire PNP étant relié à la première borne de la source d'alimentation par l'intermédiaire d'une première diode Zener (81), une deuxième diode Zener (82) étant connectée entre la base du transistor bipolaire NPN (TB) et la grille du transistor MOS logique (ML).

3. Circuit selon la revendication 1, caractérisé en ce que la tension seuil est la tension seuil (VL) entre le drain et la source d'un transistor MOS logique en-dessous de laquelle le transistor MOS logique est bloqué.

4. Circuit selon la revendication 1, caractérisé en ce que le transistor bipolaire NPN (TB) a un gain inférieur à 10.

## Patentansprüche

1. Integrierte Schaltung, welche umfaßt:
einen MOS-Leistungstransistor (MP), der an seinem Drain (DP) mit einem ersten Anschluß (1) der Versorgungsquelle und an seiner Source (SP) mit einer induktiven Last (L) verbunden ist, deren freier Anschluß mit dem zweiten Anschluß (2) der Versorgungsquelle verbunden ist, wobei diese Schaltung in einer Technologie realisiert ist, bei der auf demselben Chip mit integrierten Schaltungen MOS-Leistungstransistoren, logische MOS-Transistoren und Bipolartransistoren inkorporiert werden können, wobei das mit der Masse verbundene Substrat einerseits bei den MOS-Leistungstransistoren die Anode einer Diode, deren Kathode durch das Drain gebildet wird, und andererseits bei den Bipolartransistoren die Anode einer Diode darstellt,
deren Kathode durch den Kollektor gebildet wird, und wobei das Gate (GP) des MOS-Leistungstransistors zum einer mit einem Spannungsverstärkerschaltung (3) und zum anderen mit dem Drain (DL) eines logischen MOS-Transistors (ML) verbunden ist, und
eine Steuerschaltung (56), welche durch die Versorgungsquelle versorgt wird, einen Ausgang (63) aufweist, der mit dem Gate (GL) des logischen MOS-Transistors verbunden ist und über eine Hilfsverbindung (64) mit der Source (SL) des logischen MOS-Transistors verbunden ist, wobei die Hilfsverbindung einen großen Spannungsabfall aushalten kann,
dadurch **gekennzeichnet,** daß sie weiterhin eine Einrichtung zum Begrenzen des Spannungsabfalls Drain/Source des logischen MOS-Transistors (ML) auf eine Spannung von der Größenordnung seiner Schwellenspannung Gate/Source, wenn der MOS-Leistungstransistor (MP) leitend ist, umfaßt, was zur Folge hat, daß die Steuerschaltung das Schalten des logischen MOS-Transistors mit der von der Versorgungsquelle erhältlichen Versorgungsspannung steuern kann.

2. Schaltung nach Anspruch 1, dadurch **gekennzeichnet,** daß die Einrichtung zum Begrenzen der Sourcespannung des logischen MOS-Transistors aus einer Spannungsbegrenzerschaltung (70) besteht, welche umfaßt
- einen npn-Bipolartransistor (TB), dessen Kollektor (71) mit dem ersten Anschluß (1) der Versorgungsquelle verbunden ist, dessen Emitter (72) mit der Source (SP) des MOS-Leistungstransistors (MP) verbunden ist und dessen Basis (73) mit der Source (SL) des logischen MOS-Transistors (ML) verbunden ist,
- einen ersten pnp-Bipolartransistor (Q1), dessen Emitter (75) mit der Source des logischen MOS-Transistors verbunden ist und dessen Kollektor (76) mit dem zweiten Anschluß (2) der Versorgungsquelle verbunden ist,
- einen zweiten pnp-Bipolartransistor (Q2), dessen Basis (77-1) mit der Basis (77) des ersten pnp-Bipolartransistors verbunden ist, dessen Kollektor (78) zum einen direkt mit der Basis des ersten pnp-Bipolartransistors verbunden ist und andererseits mit dem zweiten Anschluß der Versorgungsquelle über eine Stromquelle (79) verbunden ist, wobei der Emitter (80) des zweiten pnp-Bipolartransistors mit dem ersten Anschluß der Versorgungsquelle über eine erste Zenerdiode (81) verbunden ist und eine zweite Zenerdiode (82) zwischen der Basis des npn-Bipolartransistors (TB) und dem Gate des logischen MOS-Transistors (NL) geschaltet ist.

3. Schaltung nach Anspruch 1, dadurch **gekennzeichnet,** daß die Schwellenspannung die Schwellenspannung (VL) zwischen dem Drain und der Source eines logischen MOS-Transistors ist, unterhalb der der logische MOS-Transistor blockiert ist.

4. Schaltung nach Anspruch 1, dadurch **gekennzeichnet,** daß der npn-Bipolartransistor (TB) eine Verstärkung unterhalb von 10 aufweist.

## Claims

1. An integrated circuit comprising:
a power MOS transistor (MP) connected by its drain (DP) to a first terminal (1) of a supply source and by its source (SP) to an inductive load (L), the free terminal of which is connected to the second terminal (2) of the supply source, this circuit being formed according to a technology liable to incorporate in a same integrated circuit chip power MOS transistors, logic MOS transistors and bipolar transistors, the grounded substrate constituting, on the one hand, in the power MOS transistors, the anode of a diode, the cathode of which is formed by the drain and, on the other hand, in the bipolar transistors, the anode of a diode, the cathode of which is formed by the collector, the gate (GP) of the power MOS transistor being connected, on the one hand, to a voltage booster circuit (3) and, on the other hand, to the drain (DL) of a logic MOS transistor (ML), and
a control circuit (56) fed by the supply source having an output (63) connected to the gate (GL) of the logic MOS transistor and being connected through an auxiliary connection (64) to the source (SL) of the logic MOS transistor, the auxiliary connection being adapted to withstand a substantial voltage drop,
characterized in that it further comprises means for limiting the drain/source voltage of the logic MOS transistor (ML) to a voltage substantially equal to its gate/source threshold voltage when the power MOS transistor (MP) is conductive, whereby the control circuit is capable of controlling the switching of the logic MOS transistor with the supply voltage available from the supply source.

2. A circuit according to claim 1, characterized in that said means for limiting the source voltage of the logic MOS transistor are comprised of a clamping voltage circuit (70) comprising:
- an NPN bipolar transistor (TB), the collector (71) of which is connected to a first terminal (1) of the supply source, the emitter (72) of which is connected to the source (SP) of the power MOS transistor (MP) and the base (73) of which is connected to the source (SL) of the logic MOS transistor (ML),
- a first PNP bipolar transistor (Q1), the emitter (75) of which is connected to the source of the logic MOS transistor and the collector (76) is connected to the second terminal (2) of the supply source,
- a second PNP bipolar transistor (Q2), the base (77-1) of which is connected to the base (77) of the first PNP bipolar transistor, the collector (78) of which is, on the one hand, directly connected to the base of the first PNP bipolar transistor and, on the other hand, connected to the second terminal of the supply source through a current source (79), the emitter (80) of the second PNP bipolar transistor being connected to the first terminal of the supply source through a first Zener diode (81), a second Zener diode (82) being connected between the base of the NPN bipolar transistor (TB) and the gate of the logic MOS transistor (ML).

3. A circuit according to claim 1, characterized in that said threshold voltage is the threshold voltage (V_{L}) between the drain and source of a logic MOS transistor below which the logic MOS transistor is blocked.

4. A circuit according to claim 1, characterized in that the NPN bipolar transistor (TB) has a gain lower than 10.
